# EUROPEAN PATENT APPLICATION

(11) **EP 2 615 141 A2**
(43) Date of publication of application: **17.07.2013**
(21) Application number: 13151253.5
(22) Date of filing: 15.01.2013
(51) Int. Cl.: C08L 83/08

(54) **Thermosetting Resin Composition for Semiconductor Encapsulation and Encapsulated Semiconductor Device**

(30) Priority: 16.01.2012 JP 2012006254
(71) Applicant: Shin-Etsu Chemical Co., Ltd., Tokyo (JP)
(72) Inventor: Uehara, Tatsuya, Annaka-shi, Gunma (JP); Sumita, Kazuaki, Annaka-shi, Gunma (JP)
(74) Representative: Ter Meer Steinmeister & Partner

(57) **Abstract**

A thermosetting resin composition for semiconductor encapsulation contains a both end allyl isocyanurate ring-terminated organopolysiloxane polymer as a sole base polymer and an isocyanurate ring-containing organohydrogenpolysiloxane polymer as a sole curing agent or crosslinker. When a semiconductor element array having semiconductor elements mounted on a substrate with an adhesive is encapsulated with the thermosetting resin composition, warp-free semiconductor devices having improved heat resistance and moisture resistance are obtainable.

## Description

### TECHNICAL FIELD

This invention relates to a thermosetting resin composition for semiconductor encapsulation and a semiconductor device encapsulated therewith. After a semiconductor element array having at least one semiconductor element mounted on an inorganic substrate, metal substrate or organic substrate with an adhesive or die bonding agent, or a large-size silicon wafer having semiconductor elements formed therein is encapsulated with a thermosetting resin composition in the cured state, substantially warp-free semiconductor devices having improved heat resistance and moisture resistance are obtainable. The resin composition enables lump-sum encapsulation on the wafer level, and the encapsulating resin can be readily polished and diced.

### BACKGROUND ART

Semiconductor devices are resin encapsulated by various techniques including transfer molding, potting, and screen printing of liquid encapsulating resin. The recent demand to reduce the size and profile of electronic equipment calls for further miniaturization of semiconductor elements. It is even required to resin encapsulate thin-profile packages including stacked silicon dies and having a thickness of up to 500 µm.

On small-diameter substrates such as wafers having a diameter of about 8 inches, the state-of-the-art technology implements encapsulation without substantial problems. On those substrates with a diameter of more than 12 inches, however, semiconductor elements can be separated from the metal or other substrates because of shrinkage stresses of epoxy resins after encapsulation, raising a problem that inhibits mass-scale fabrication.

To overcome the above problem associated with increasing diameter of wafers and metal substrates, the shrinkage stress of a resin upon curing must be reduced by loading the resin with at least 90% by weight of a filler or rendering the resin low modulus.

In the current trend toward stacking of plural semiconductor elements, the encapsulating layer becomes thick. Therefore, the mainstream semiconductor device is obtained by polishing the encapsulating resin layer to a thin profile. Some problems arise when the encapsulating resin layer is polished. If the resin encapsulant loaded with at least 90% by weight of filler is used, the blade of the dicing tool can be damaged, which necessitates to exchange the blade frequently, leading to an increased cost. Additionally, polishing must be done under high pressure, with the risk that the semiconductor elements can be damaged or the wafer be broken. In the case of low modulus resin materials as typified by conventional silicone compounds, because of their softness, problems of resin clogging and cracking may arise during polishing.

Compositions comprising an isocyanurate ring-containing polymer and an isocyanurate ring-containing hydrogen-terminated polysiloxane polymer are known in the art. For example, Patent Document 1 discloses a composition comprising an epoxy ring-opening polymerization polymer of polysiloxane resulting from addition reaction of diallyl monoglycidyl isocyanurate to hydrosilyl-containing polysiloxane. Patent Document 2 discloses a composition comprising an isocyanurate ring-containing polysiloxane and a hydrosilyl-containing polysiloxane. Patent Document 3 discloses an addition cure type composition comprising triallyl isocyanurate and a hydrosilyl-containing polysiloxane. Patent Documents 4 to 6 disclose addition cure type compositions comprising a polysiloxane containing isocyanurate ring and hydrosilyl and an alkenyl-containing curing agent. The isocyanurate ring-containing polymer compositions of Patent Documents 1 and 2 are flexible, but incompatible with crosslinkers because the base component contains siloxane bonds. The isocyanurate ring-containing polymers of Patent Documents 1 and 2 are difficult to cure by addition reaction because the position of alkenyl groups is indefinite, failing to take the advantage of hydrosilylation or addition reaction, that is, quick cure reaction. The isocyanuric acid-containing polymer compositions of Patent Documents 3 to 6 are rigid and less flexible because of a high crosslinking density. As used herein, the term "hydrosilyl" refers to Si-H.

There exists a demand for a cured polymer obtained from addition reaction of an isocyanurate ring-containing polysiloxane and a hydrosilyl-containing polysiloxane and having flexibility, cure properties, compatibility and resistance to water vapor permeation.

### Citation List

Patent Document 1: JP-A 2008-143954
Patent Document 2: JP-A 2008-150506
Patent Document 3: JP-A H09-291214 (EP 0803529)
Patent Document 4: JP 4073223
Patent Document 5: JP-A 2006-291044
Patent Document 6: JP-A 2007-009041

### SUMMARY OF INVENTION

An object of the invention is to provide a thermosetting resin composition which is used to encapsulate a semiconductor element array having at least one semiconductor element mounted on an inorganic substrate, metal substrate or organic substrate with an adhesive or die bonding agent, or a large-size silicon wafer having semiconductor elements formed therein, yielding substantially warp-free semiconductor devices having improved heat resistance and moisture resistance, and which enables lump-sum encapsulation on the wafer level, and allows for easy polishing and dicing. Another object is to provide a semiconductor device encapsulated with the thermosetting resin composition.

The inventors have found that when a semiconductor device is encapsulated with a thermosetting resin composition comprising a both end allyl isocyanurate ring-terminated organopolysiloxane polymer as a sole base polymer, an isocyanurate ring-containing hydrogen-terminated polysiloxane polymer as a sole curing agent, and a spherical inorganic filler having a specific particle size distribution, the composition offers the advantages of effective polishing, water resistance and gas permeability as compared with prior art silicone compounds. It has also been found that even when a large-size wafer is encapsulated with the composition, the composition offers the advantages of reduced warpage, tack-free surface of the cured composition, and very high versatility. The invention is predicated on these findings.

In one aspect, the invention provides a thermosetting resin composition for semiconductor encapsulation comprising
(A) an organopolysiloxane polymer having an allyl isocyanurate ring structure at both ends of its molecular chain, represented by the general formula (1) as an alkenyl-containing organopolysiloxane, 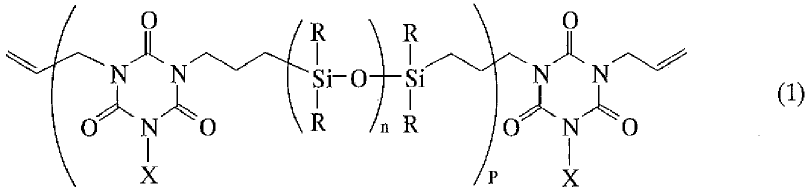 wherein X is each independently a monovalent hydrocarbon group free of aliphatic unsaturation, R is each independently alkyl or phenyl, n is an integer of 1 to 50, and P is an integer of 1 to 30,
(B) an isocyanurate ring-containing organohydrogenpolysiloxane polymer having at least two silicon-bonded hydrogen atoms (Si-H groups) at ends of its siloxane chain, represented by the general formula (2) as an epoxy-free organohydrogenpolysiloxane, 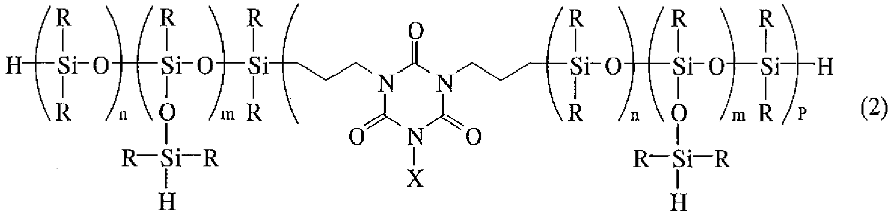 wherein X is each independently a monovalent hydrocarbon group free of aliphatic unsaturation, R is each independently alkyl or phenyl, n is an integer of 1 to 50, m is an integer of 0 to 5, and P is an integer of 1 to 30, wherein the recurring siloxane units may be randomly linked, in such an amount that 0.8 to 4.0 moles of Si-H groups in component (B) are present per mole of allyl groups in component (A),
(C) a catalytic amount of a cure accelerator, and
(D) a spherical inorganic filler consisting of (D-1) a fraction having an average particle size of 10.0 to 50.0 µm, (D-2) a fraction having an average particle size of 1.1 to 5.0 µm, and (D-3) a fraction having an average particle size of 0.1 to 1.0 µm in a weight ratio (D-1) : (D-2) : (D-3) of 95-70 : 3-20 : 2-10, provided that the total of (D-1), (D-2) and (D-3) is 100, in an amount of 30 to 900 parts by weight per 100 parts by weight of components (A) and (B) combined. The composition should be free of any alkenyl-containing organopolysiloxane other than component (A) and any epoxy-free organohydrogenpolysiloxane other than component (B),

In a preferred embodiment, the spherical inorganic filler (D) is spherical silica. Also preferably, the spherical inorganic filler (D) has been surface treated with a silane coupling agent. The silane coupling agent is preferably selected from among vinytrimethoxysilane, vinyltriethoxysilane,
2-(3,4-epoxycyclohexyl)ethyltrimethoxysilane,
3-glycidoxypropylmethyldimethoxysilane,
3-glycidoxypropyltrimethoxysilane,
3-glycidoxypropylmethyldiethoxysilane,
3-glycidoxypropyltriethoxysilane, p-styryltrimethoxysilane,
3-methacryloxypropylmethyldimethoxysilane,
3-methacryloxypropyltrimethoxysilane,
3-methacryloxypropylmethyldiethoxysilane,
3-methacryloxypropyltriethoxysilane,
3-acryloxypropyltriethoxysilane, and
3-ureidopropyltriethoxysilane, and mixtures thereof.

In another aspect, the invention provides a resin-encapsulated semiconductor device fabricated by coating the thermosetting resin composition defined above to one surface of a silicon wafer having at least one semiconductor element formed therein in entirety under pressure or under reduced pressure in a vacuum atmosphere, heat curing the composition to encapsulate the wafer with a cured resin layer, polishing the cured resin layer, and dicing the wafer into singulated devices.

In summary, the thermosetting resin composition for semiconductor encapsulation is characterized in that an organopolysiloxane polymer blocked with an allyl isocyanurate ring, typically monomethylallyl isocyanurate ring, at both ends of its molecular chain, represented by formula (1) is used as a sole base polymer, and an isocyanurate ring-containing organohydrogenpolysiloxane polymer having at least two silicon-bonded hydrogen atoms (Si-H groups) at ends of its siloxane chain, represented by formula (2) is used as a sole curing agent or crosslinker.

### ADVANTAGEOUS EFFECTS OF INVENTION

When a semiconductor element array having at least one semiconductor element mounted on an inorganic, metal or organic substrate with an adhesive or die bonding agent, or a large-size silicon wafer having semiconductor elements formed therein is encapsulated with the inventive thermosetting resin composition, substantially warp-free semiconductor devices having improved heat resistance and moisture resistance are obtainable. The thermosetting resin composition enables lump-sum encapsulation on the wafer level, and allows for easy polishing and dicing.

### DESCRIPTION OF EMBODIMENTS

Briefly stated, the invention is directed to a thermosetting resin composition for semiconductor encapsulation comprising
(A) an organopolysiloxane polymer having an allyl isocyanurate ring structure at both ends of its molecular chain represented by formula (1) as an alkenyl-containing organopolysiloxane,
(B) an isocyanurate ring-containing organohydrogenpolysiloxane polymer having at least two silicon-bonded hydrogen atoms (Si-H groups) at ends of its siloxane chain, represented by formula (2) as an epoxy-free organohydrogenpolysiloxane,
(C) a cure accelerator, and
(D) a spherical inorganic filler consisting of (D-1) a fraction having an average particle size of 10.0 to 50.0 µm, (D-2) a fraction having an average particle size of 1.1 to 5.0 µm, and (D-3) a fraction having an average particle size of 0.1 to 1.0 µm in a weight ratio (D-1) : (D-2) : (D-3) of 95-70 : 3-20 : 2-10, provided that the total of (D-1), (D-2) and (D-3) is 100.
The composition does not contain any alkenyl-containing organopolysiloxane other than component (A) and any epoxy-free organohydrogenpolysiloxane other than component (B).

The thermosetting resin composition for semiconductor encapsulation is characterized in that only an organopolysiloxane polymer blocked with an allyl isocyanurate ring, typically monomethylallyl isocyanurate ring, at both ends of its molecular chain, represented by formula (1), that is, an organopolysiloxane polymer having an alkenyl group (typically allyl group) at both ends of its molecular chain is used as an alkenyl-containing organopolysiloxane serving as a base polymer, and only an isocyanurate ring-containing organohydrogenpolysiloxane polymer having at least two silicon-bonded hydrogen atoms (Si-H groups) at ends of its siloxane chain, represented by formula (2) is used as an epoxy-free organohydrogenpolysiloxane serving as a curing agent or crosslinker. The use of these polymers in combination ensures that a cured product capable of taking advantage of hydrosilylation or addition reaction is obtainable.

Component (A) is an organopolysiloxane polymer having an allyl isocyanurate ring structure, typically monomethylallyl isocyanurate ring, at both ends of its molecular chain, represented by the general formula (1). In the inventive composition, the alkenyl-containing organopolysiloxane serving as a base polymer consists of this organopolysiloxane polymer having an allyl isocyanurate ring structure at both ends of its molecular chain represented by formula (1), and no other alkenyl-containing organopolysiloxanes are present. 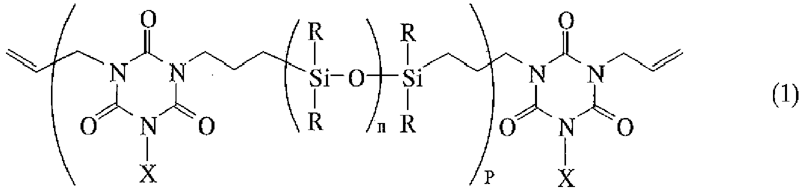 Herein X is each independently a monovalent hydrocarbon group free of aliphatic unsaturation, R is each independently alkyl or phenyl, n is an integer of 1 to 50, and P is an integer of 1 to 30.

In formula (1), R is each independently selected from alkyl groups of 1 to 10 carbon atoms such as methyl, ethyl and propyl, and phenyl. Inter alia, methyl is preferred for curing properties, flexibility and ease of synthesis. More preferably methyl accounts for at least 50 mol% (i.e., 50 to 100 mol%) of the entire R groups.

X is each independently selected from monovalent hydrocarbon groups free of aliphatic unsaturation, for example, alkyl groups of 1 to 10 carbon atoms such as methyl, ethyl and propyl, and aryl groups of 6 to 10 carbon atoms such as phenyl. Most preferably X is methyl.

The subscript n is an integer of 1 to 50, preferably 1 to 30, and P is an integer of 1 to 30, preferably 1 to 10, and more preferably 1 to 8.

The organopolysiloxane polymer generally has a weight average molecular weight (Mw) of 500 to 10,000, preferably 600 to 5,000. It generally has a viscosity of 0.5 to 1,000 Pa-s at 25°C, preferably 1 to 100 Pa-s at 25°C. It is noted that Mw may be determined by gel permeation chromatography (GPC) using toluene or tetrahydrofuran as developing solvent; and that the viscosity may be measured by a rotational viscometer, typically BL, BH, BS or cone/plate type.

The isocyanurate ring-containing organopolysiloxane polymer as component (A) may be prepared, for example, by hydrosilylation or addition reaction of a diallyl isocyanurate having the general formula (3) with a hydrogensiloxy-terminated organopolysiloxane having the general formula (4). The addition reaction may be performed by a prior art well-known technique, typically at a temperature of room temperature (25°C) to 250°C, preferably 50 to 180°C for a time of 0.1 to 120 hours, preferably 1 to 10 hours.

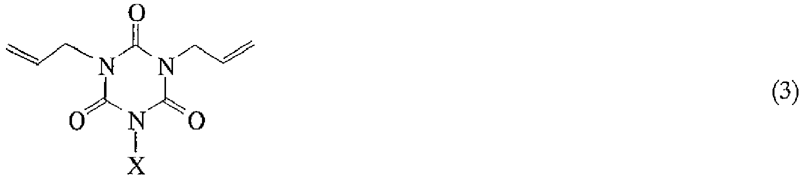

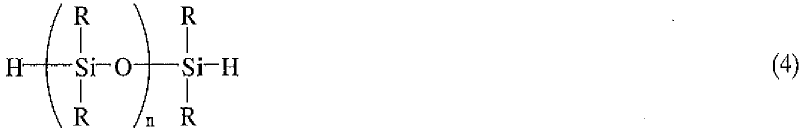

Herein X, R and n are as defined above.

The diallyl isocyanurate having formula (3) and the hydrogensiloxy-terminated organopolysiloxane having formula (4) are reacted in such amounts that 0.1 to 0.9 equivalent, more preferably 0.4 to 0.7 equivalent of Si-H group in formula (4) is present per mole of allyl group in formula (3), that is, in an allyl excess system. Then an organopolysiloxane polymer having a diallyl isocyanurate ring at both ends is obtained.

For the reaction, a catalyst may be used, for example, compounds containing platinum group metals such as platinum, rhodium and palladium. Inter alia, platinum-containing compounds are preferred, for example, hexachloroplatinate(IV) hexahydrate, platinum-carbonylvinylmethyl complex, platinum-divinyltetramethyldisiloxane complex, platinum-cyclovinylmethylsiloxane complex, platinum-octylaldehyde/octanol complex, and platinum on active carbon. The catalyst is preferably used in such an amount as to give 0.01 to 10,000 ppm, more preferably 0.1 to 100 ppm of the metal based on the compound having formula (3).

On preparation of the isocyanurate ring-containing organopolysiloxane polymer, a solvent may be added if necessary. Suitable solvents include toluene, xylene, mesitylene, diethylbenzene, tetrahydrofuran, diethyl ether, 1,4-dioxane, and diphenyl ether.

Component (B) is an isocyanurate ring-containing organohydrogenpolysiloxane polymer having at least two silicon-bonded hydrogen atoms (Si-H groups) at ends of its siloxane chain, represented by the general formula (2). In the inventive composition, the organohydrogenpolysiloxane free of an epoxy group which is an adhesive functional group, serving as a curing agent or crosslinker consists of the isocyanurate ring-containing organohydrogenpolysiloxane polymer having formula (2), and no other organohydrogenpolysiloxanes are present.

Characteristically component (B) consists of an organohydrogenpolysiloxane having at least two hydrogen atoms bonded to silicon atoms (Si-H groups) at ends of its siloxane chain (i.e., in monofunctional siloxy unit), sometimes referred to as isocyanurate ring-containing hydrogen-terminated polysiloxane polymer. The inclusion of at least two, preferably 2 to 50, highly reactive hydrogen atoms bonded to silicon atoms at ends of the siloxane chain (i.e., Si-H groups in (H) (R)₂SiO_{1/2} units) ensures quick hydrosilylation or addition reaction with alkenyl groups (allyl groups) at both ends of the molecular chain in component (A). 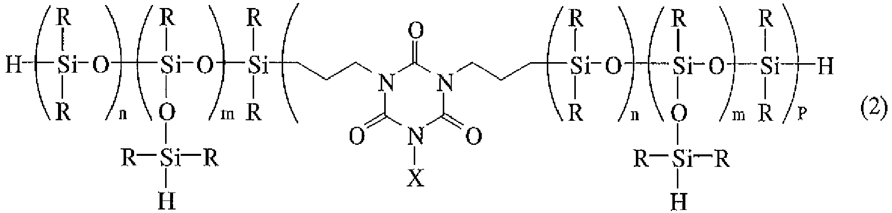 Herein X is each independently a monovalent hydrocarbon group free of aliphatic unsaturation, R is each independently alkyl or phenyl, n is an integer of 1 to 50, m is an integer of 0 to 5, and P is an integer of 1 to 30. The recurring siloxane units may be randomly linked.

In formula (2), R is each independently selected from alkyl groups of 1 to 10 carbon atoms such as methyl, ethyl and propyl, and phenyl. Inter alia, methyl is preferred for curing properties, flexibility and ease of synthesis. More preferably methyl accounts for at least 50 mol% (i.e., 50 to 100 mol%) of the entire R groups.

X is each independently selected from monovalent hydrocarbon groups free of aliphatic unsaturation, for example, alkyl groups of 1 to 10 carbon atoms such as methyl, ethyl and propyl, and aryl groups of 6 to 10 carbon atoms such as phenyl. Most preferably X is methyl.

The subscript n is an integer of 1 to 50, preferably 1 to 30, m is an integer of 0 to 5, preferably 0 to 2, and P is an integer of 1 to 30, preferably 1 to 10, and more preferably 1 to 8.

The organohydrogenpolysiloxane polymer as component (B) generally has a weight average molecular weight (Mw) of 500 to 10,000, preferably 600 to 5,000. It generally has a viscosity of 0.1 to 100 Pa-s at 25° C, preferably 0.5 to 10 Pa-s at 25° C.

The isocyanurate ring-containing hydrogen-terminated polysiloxane polymer as component (B) may be prepared, for example, by hydrosilylation or addition reaction of a diallyl isocyanurate having the general formula (5) with a hydrogensiloxy-terminated organopolysiloxane having the general formula (6). The addition reaction may be performed by a prior art well-known technique, typically at a temperature of room temperature (25°C) to 250°C, preferably 50 to 180° C for a time of 0.1 to 120 hours, preferably 1 to 10 hours. 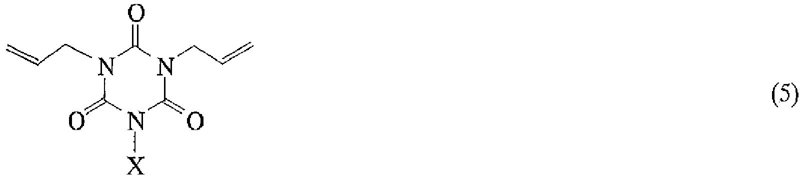 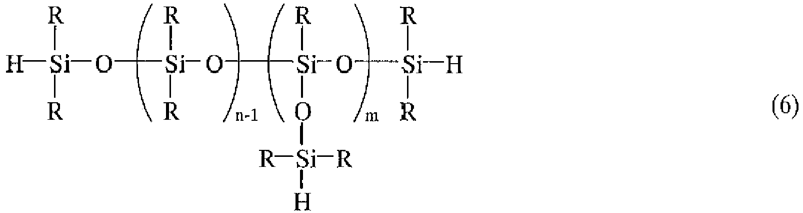 Herein X, R, n and m are as defined above. The recurring siloxane units may be randomly linked.

The diallyl isocyanurate having formula (5) and the hydrogensiloxy-terminated organopolysiloxane having formula (6) are reacted in such amounts that 1.1 to 5.0 equivalents, more preferably 1.1 to 3.5 equivalents of Si-H group in formula (6) is present per mole of allyl group in formula (5), that is, in an Si-H excess system. Then an isocyanurate ring-containing organohydrogenpolysiloxane polymer having at least two hydrogensiloxy groups at ends of its siloxane chain is obtained.

Examples of the hydrogensiloxy-terminated organopolysiloxane having formula (6) include those of the following formulae (7) to (11).

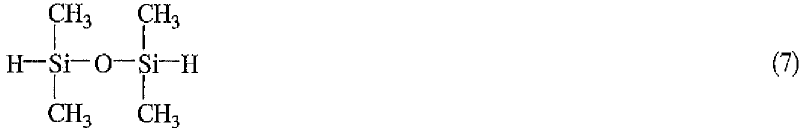

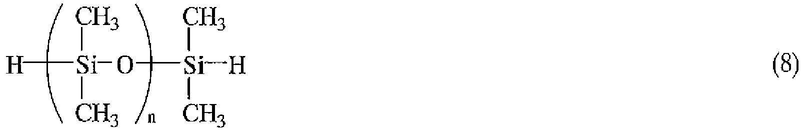

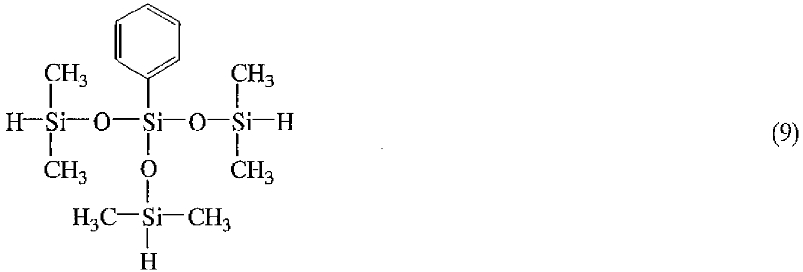

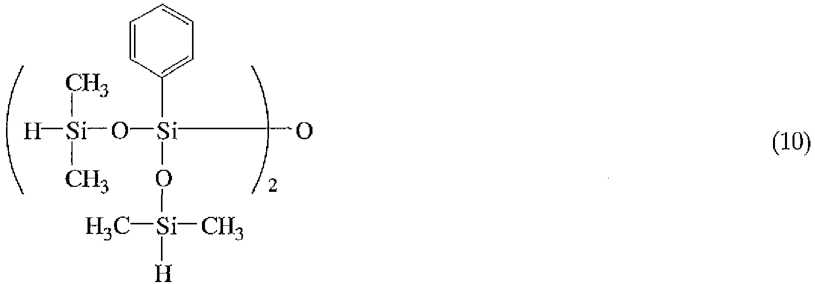

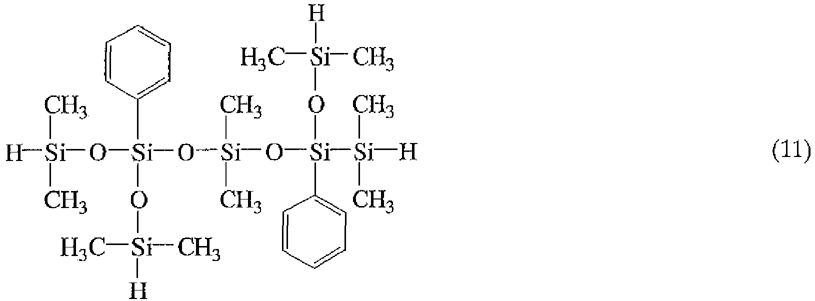

For the reaction, a catalyst may be used, for example, compounds containing platinum, rhodium and palladium. Inter alia, platinum-containing compounds are preferred, for example, hexachloroplatinate(IV) hexahydrate, platinum-carbonylvinylmethyl complex, platinum-divinyltetramethyldisiloxane complex, platinum-cyclovinylmethylsiloxane complex, platinum-octylaldehyde/octanol complex, and platinum on active carbon. The catalyst is preferably used in such an amount as to give 0.01 to 10,000 ppm, more preferably 0.1 to 100 ppm of the metal based on the compound having formula (5).

On preparation of the organohydrogenpolysiloxane polymer, a solvent may be added if necessary. Suitable solvents include toluene, xylene, mesitylene, diethylbenzene, tetrahydrofuran, diethyl ether, 1,4-dioxane, and diphenyl ether.

Examples of the organohydrogenpolysiloxane polymer prepared by the above method include those of the general formulae (12) and (13).

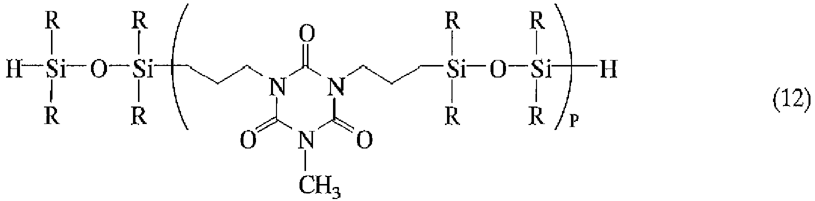

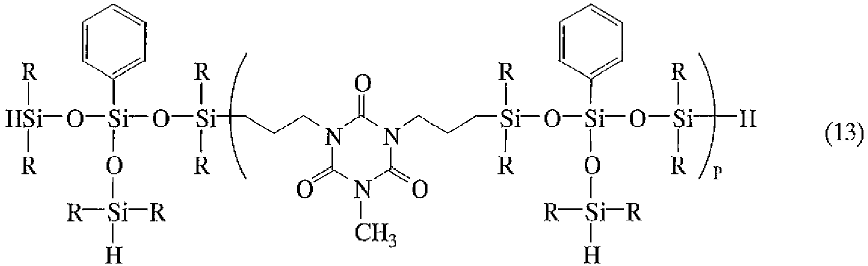

Herein R and P are as defined above.

The both end allyl isocyanurate ring-terminated organopolysiloxane polymer as component (A) and the isocyanurate ring-containing hydrogen-terminated polysiloxane polymer as component (B) are used in such amounts that 0.8 to 4.0 moles of Si-H group in component (B) is present per mole of allyl group in component (A). Preferably a molar ratio of Si-H group to allyl group is from 1.0 to 3.0. If the Si-H/allyl ratio is less than 0.8 or more than 4.0, then the composition may be under-cured, or the resin surface after compression molding may be mottled.

Crosslinking between isocyanurate ring-containing organopolysiloxane polymers as components (A) and (B) provides a cured product with a low modulus as well as satisfactory mechanical properties, heat resistance, electrical insulating properties, chemical resistance, water resistance, and gas permeability.

For the purpose of encapsulation of semiconductor elements, the both end allyl isocyanurate ring-blocked organopolysiloxane polymer as the base polymer and the isocyanurate ring-containing hydrogen-terminated polysiloxane polymer as the curing agent or crosslinker should preferably have minimal contents of a halide ion such as chloride and an alkali ion such as sodium, typically up to 10 ppm of either ion upon extraction at 120°C.

Component (C) is a cure accelerator or cure catalyst which may be a catalyst for hydrosilylation or addition reaction. Suitable catalysts include platinum group metal catalysts such as platinum and palladium-based catalysts and iron oxide. Inter alia, platinum group metal catalysts are preferred, which include platinum, palladium and rhodium-based catalysts. From the standpoint of cost or the like, preference is given to platinum-based catalysts such as platinum, platinum black, and chloroplatinic acid. Typical examples include H₂PtCl₆-xH₂O, K₂PtCl₆, KHPtCl₆-xH₂O, K₂PtCl₄, K₂PtCl₄-xH₂O, and PtO₂-xH₂O wherein x is a positive integer, and complexes thereof with hydrocarbons such as olefins, alcohols, or vinyl-containing organopolysiloxanes. These catalysts may be used alone or in admixture of two or more.

The cure accelerator is used in a catalytic amount, i.e., an amount sufficient to accelerate cure. The platinum group metal catalyst is used in such an amount as to give 0.1 to 500 ppm of the platinum group metal based on the weight of components (A) and (B) combined. Outside the range, the composition may be under-cured, or the composition may suffer from difficulty of working due to a short pot-life and an acute viscosity buildup caused by fast cure.

Component (D) is a spherical inorganic filler. The filler is not particularly limited as long as it is spherical. Spherical silica is preferred. The spherical inorganic filler consists of (D-1) a large-size fraction having an average particle size of 10.0 to 50.0 µm, (D-2) a medium-size fraction having an average particle size of 1.1 to 5.0 µm, and (D-3) a small-size fraction having an average particle size of 0.1 to 1.0 µm, which are combined and used in the closest packing state, specifically in a weight ratio (D-1) (D-2) : (D-3) of 95-70 : 3-20 : 2-10, preferably 92-78 : 5-15 : 3-7, provided that the total of (D-1), (D-2) and (D-3) is 100. The closest packing mix ratio (weight ratio) is large-size fraction (D-1): medium-size fraction (D-2) : small-size fraction (D-3) = 85:10:5, for example, but not limited thereto.

The spherical inorganic filler, typically spherical silica as component (D) may have been surface treated with a silane coupling agent before it is added to and mixed with the composition. Suitable silane coupling agents include vinyltrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltriethoxysilane, and 3-ureidopropyltriethoxysilane, which may be used alone or in admixture. Inter alia, 3-methacryloxypropyltrimethoxysilane is preferred.

The amount of the coupling agent used and the surface treatment method are not particularly limited. The amount of the coupling agent used is preferably 0.5 to 2.0% by weight, more preferably 0.5 to 1.0% by weight based on the weight of the spherical inorganic filler as component (D).

When the spherical inorganic filler, typically spherical silica, as component (D) is added to the thermosetting resin composition, the amount of component (D), that is, the total amount of fractions (D-1) to (D-3) is 30 to 900 parts by weight, preferably 40 to 600 parts by weight, per 100 parts by weight of the both end allyl isocyanurate ring-terminated organopolysiloxane polymer as base polymer (A) and the isocyanurate ring-containing hydrogen-terminated polysiloxane polymer as curing agent (B) combined. With respect to the amount of the filler per 100 parts by weight of components (A) and (B) combined, if the amount is less than 30 parts by weight, a sufficient strength is not obtainable, and if the amount is more than 900 parts by weight, the viscosity builds up, leading to a less flow, short filling, and incomplete encapsulation of semiconductor elements arranged on a sub-mount.

To the thermosetting resin composition, any additives may be added if desired. Suitable additives include an adhesion improver, for example, an organosilicon compound having an epoxy group such as 3-glycidoxypropyltrimethoxysilane or an epoxy-containing organohydrogensiloxane having the structural formula (14), shown below; a cure retarder, for example, ethynyl methyl decyl carbinol, organophosphorus compounds such as triphenylphosphine, organic nitrogen-containing compounds such as tributylamine, tetramethylethylenediamine and benzotriazole; and colorants, for example, carbon blacks such as acetylene black and furnace black. These additives may be added insofar as the objects of the invention are not compromised.

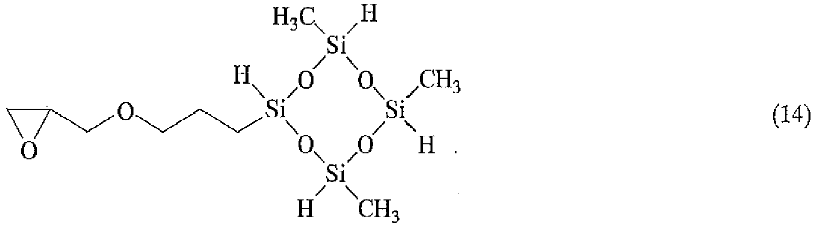

The thermosetting resin composition may be prepared by uniformly mixing the foregoing components in a conventional manner. The thermosetting resin composition may be cured by heating. Suitable curing conditions include a temperature of 110 to 200°C, especially 120 to 180°C and a time of 1 to 6 hours, especially 2 to 3 hours.

Since the thermosetting resin composition cures into a product having a low modulus, satisfactory mechanical properties, heat resistance, electrical insulating properties, chemical resistance, water resistance, and gas permeability, it is best suited as the encapsulant for semiconductor members, typically for sealing of large-size wafers and overall encapsulation of substrates.

When a semiconductor element array having at least one semiconductor element mounted on an inorganic, metal or organic substrate with an adhesive or die bonding agent, or a large-size silicon wafer having semiconductor elements formed therein is encapsulated with the thermosetting resin composition, substantially warp-free semiconductor devices having improved heat resistance and moisture resistance are obtainable. The resin composition enables lump-sum encapsulation on the wafer level, and the encapsulating resin in the cured state can be readily polished and diced.

Another embodiment provides a resin-encapsulated semiconductor device associated with a situation wherein a silicon wafer or substrate having at least one semiconductor element formed therein is entirely encapsulated in lump sum with a thermosetting resin composition in the cured state. The resin-encapsulated semiconductor device is obtained by coating the thermosetting resin composition, defined above, to one surface of the silicon wafer under pressure or under reduced pressure in a vacuum atmosphere, heat curing the composition to encapsulate the wafer with a cured resin layer, polishing the cured resin layer, and dicing the wafer into singulated devices.

### EXAMPLE

Examples of the invention are given below by way of illustration and not by way of limitation. In Examples, room temperature is 25°C, all parts are by weight, and Vi is vinyl. The viscosity is a measurement at 25°C by a rotational viscometer as identified in Test Method.

### Synthesis Example 1

A 2-L separable flask was charged with 400 g (1.79 moles) of monomethyldiallyl isocyanurate, 400 g of toluene, and 0.32 g of a chloroplatinic acid toluene solution (containing 0.5 wt% of Pt). The solution was heated at 100°C whereupon 120 g (0.89 mole) of 1,1,3,3-tetramethyldisiloxane having the following formula (15) was added dropwise to the solution, followed by stirring at 100°C for 8 hours. Toluene was distilled off in vacuum, yielding a colorless clear liquid.

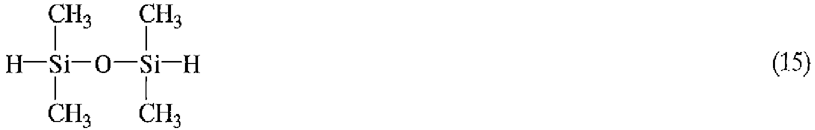

On analysis by ¹H-NMR spectroscopy, the peak (near 4.6 ppm) assigned to Si-H proton extinguished and the peak (near 5.0-5.4 and 5.7-6.0 ppm) assigned to vinyl proton was kept. It was confirmed that some of allyl groups in monomethyldiallyl isocyanurate had reacted with the 1,1,3,3-tetramethyldisiloxane. The product had a weight average molecular weight of 1,200 on GPC analysis. Average degree of polymerization 2.6, vinyl value 2.48 mmol/g, viscosity 3.0 Pa-s at 25°C.

The product was a mixture of unreacted reactant and reaction products having different degrees of polymerization. GPC and NMR analyses demonstrated that the product, designated Compound A, was composed mainly of the unreacted reactant (monomethyldiallyl isocyanurate) and a compound having the following formula (16).

On GPC analysis, Compound A consisted of 18.5 wt% of the unreacted reactant (monomethyldiallyl isocyanurate), 27.3 wt% of compound (16) wherein P=1, 22.3 wt% of compound (16) wherein P=2, 14.8 wt% of compound (16) wherein P=3, 8.1 wt% of compound (16) wherein P=4, and 9.0 wt% of compound (16) wherein P=5 and higher.

The compound of formula (16) isolated by removing the unreacted reactant (i.e., formula (16) wherein P=0) from Compound A had a weight average molecular weight of 1,468 (P = 3.3 on average).

### (Compound A)

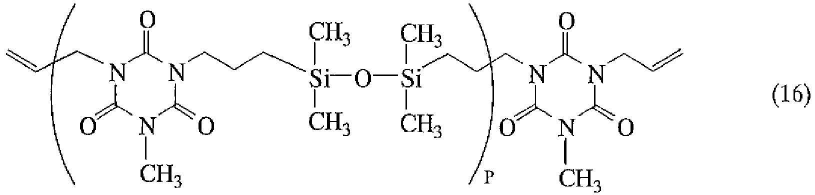

### Synthesis Example 2

A 3-L separable flask was charged with 900 g (2.73 moles) of hydrogen-terminated siloxane having formula (17), i.e., tris(dimethylhydrogensiloxy)phenylsilane, and 900 g of toluene. The solution was heated at 100°C whereupon 0.71 g of a chloroplatinic acid toluene solution (containing 0.5 wt% of Pt) was added dropwise. Thereafter, 300 g (1.34 moles) of monomethyldiallyl isocyanurate and 300 g of toluene were added dropwise to the solution, followed by stirring at 100°C for 8 hours. Toluene was distilled off in vacuum, yielding a colorless clear liquid.

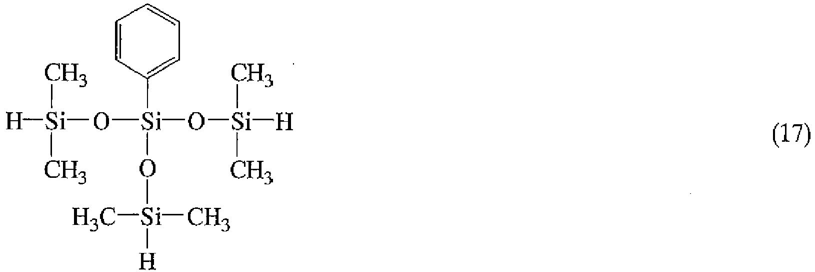

On analysis by ¹H-NMR spectroscopy, the peak (near 5.0-5.4 and 5.7-6.0 ppm) assigned to vinyl proton extinguished, indicating that the reactant, monomethyldiallyl isocyanurate was completely consumed. The peak (near 4.6 ppm) assigned to Si-H proton was kept, indicating that the allyl group on monomethyldiallyl isocyanurate had reacted with Si-H group at an end of hydrogen-terminated siloxane of formula (17). The product had a weight average molecular weight of 2,470 on GPC analysis. Si-H value 4.54 mmol/g, viscosity 0.4 Pa-s at 25°C.

The product was a mixture of reaction products having different degrees of polymerization. GPC and NMR analyses demonstrated that the product, designated Compound B, was composed mainly of a compound having the following formula (18). Specifically, Compound B consisted of 12.4 wt% of compound (18) wherein P=1, 23.3 wt% of compound (18) wherein P=2, 20.0 wt% of compound (18) wherein P=3, 14.6 wt% of compound (18) wherein P=4, 11.8 wt% of compound (18) wherein P=5, and 17.9 wt% of compound (18) wherein P=6 and higher, P = 3.8 on average.

### (Compound B)

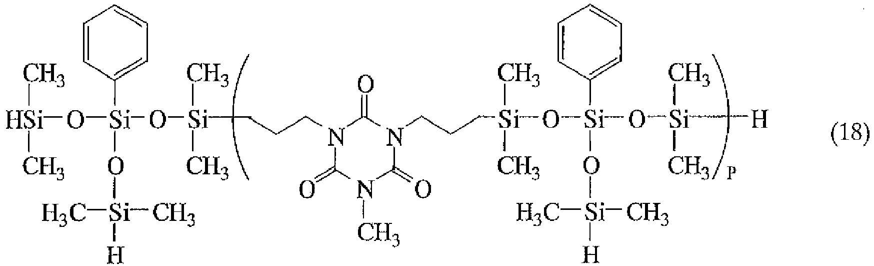

### Example 1

A resin composition containing Compound A as the sole base polymer and Compound B as the sole curing agent in a Si-H/allyl ratio of 1.0 and having a silica filler loading of 60 wt% was prepared in accordance with the following formulation.

| # | Component | | pbw |
|---|---|---|---|
| 1 | Base polymer: Compound A | | 58.0 |
| 2 | Curing agent: Compound B | | 37.0 |
| 3 | | Cure accelerator: | |
| | | octyl alcohol-modified chloroplatinic acid solution with a concentration of 2 wt% Pt | 0.5 |
| 4 | Filler: spherical silica* | | 157.8 |
| 5 | Epoxy silane coupling agent: | | |
| | | 3-glycidoxypropyltrimethoxysilane | 5.0 |
| 6 | Cure inhibitor: | | |
| | | ethynyl methyl decyl carbinol of formula (19) | 0.5 |
| 7 | Colorant: acetylene black (Denka Black®) | | 3.0 |

| | | | |
|---|---|---|---|
| * Spherical silica consisted of large-size silica (average particle size d=10 µm), medium-size silica (d=2 µm) and small-size silica (d=0.8 µm) in a weight ratio of 85:10:5, which was surface treated with 1 wt% of 3-methacryloxypropyltrimethoxysilane in Henschel mixer at room temperature for 240 seconds. | | | |

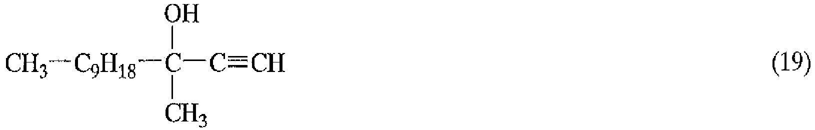

Acetylene black is commercially available as Denka Black® from Denki Kagaku Kogyo K.K.

A liquid resin composition was prepared by agitating and mixing components #1 to #7 on a planetary mixer, milling on a three-roll mill with a pitch of 80 µm in three passes, and mixing on a planetary mixer in vacuum.

### Example 2

A resin composition containing Compound A as the sole base polymer and Compound B as the sole curing agent in a Si-H/allyl ratio of 1.8 and having a silica filler loading of 60 wt% was prepared in accordance with the following formulation.

| # | Component | | pbw |
|---|---|---|---|
| 1 | Base polymer: Compound A | | 43.9 |
| 2 | Curing agent: Compound B | | 51.1 |
| 3 | Cure accelerator: | | |
| | | octyl alcohol-modified chloroplatinic acid solution with a concentration of 2 wt% Pt | 0.5 |
| 4 | Filler: spherical silica* | | 157.8 |
| 5 | Epoxy silane coupling agent: | | |
| | | 3-glycidoxypropyltrimethoxysilane | 5.0 |
| 6 | Cure inhibitor: | | |
| | | ethynyl methyl decyl carbinol of formula (19) | 0.5 |
| 7 | Colorant: acetylene black (Denka Black®) | | 3.0 |

| | | | |
|---|---|---|---|
| * Same as in Example 1 | | | |

A liquid resin composition was prepared by agitating and mixing components #1 to #7 on a planetary mixer, milling on a three-roll mill with a pitch of 80 µm in three passes, and mixing on a planetary mixer in vacuum.

### Example 3

A resin composition containing Compound A as the sole base polymer and Compound B as the sole curing agent in a Si-H/allyl ratio of 2.2 and having a silica filler loading of 60 wt% was prepared in accordance with the following formulation.

| # | Component | | pbw |
|---|---|---|---|
| 1 | Base polymer: Compound A | | 39.1 |
| 2 | Curing agent: Compound B | | 55.9 |
| 3 | Cure accelerator: | | |
| | | octyl alcohol-modified chloroplatinic acid solution with a concentration of 2 wt% Pt | 0.5 |
| 4 | Filler: spherical silica* | | 157.8 |
| 5 | Epoxy silane coupling agent: | | |
| | | 3-glycidoxypropyltrimethoxysilane | 5.0 |
| 6 | Cure inhibitor: | | |
| | | ethynyl methyl decyl carbinol of formula (19) | 0.5 |
| 7 | Colorant: acetylene black (Denka Black®) | | 3.0 |

| | | | |
|---|---|---|---|
| * Same as in Example 1 | | | |

A liquid resin composition was prepared by agitating and mixing components #1 to #7 on a planetary mixer, milling on a three-roll mill with a pitch of 80 µm in three passes, and mixing on a planetary mixer in vacuum.

### Example 4

A resin composition containing Compound A as the sole base polymer and Compound B as the sole curing agent in a Si-H/allyl ratio of 2.2 and having a silica filler loading of 65 wt% was prepared in accordance with the following formulation.

| # | Component | | pbw |
|---|---|---|---|
| 1 | Base polymer: Compound A | | 39.1 |
| 2 | Curing agent: Compound B | | 55.9 |
| 3 | Cure accelerator: | | |
| | | octyl alcohol-modified chloroplatinic acid solution with a concentration of 2 wt% Pt | 0.5 |
| 4 | Filler: spherical silica* | | 195.4 |
| 5 | Epoxy silane coupling agent: | | |
| | | 3-glycidoxypropyltrimethoxysilane | 5.0 |
| 6 | Cure inhibitor: | | |
| | ethynyl methyl decyl carbinol of formula (19) | | 0.5 |
| 7 | Colorant: acetylene black (Denka Black®) | | 3.0 |

| | | | |
|---|---|---|---|
| * Same as in Example 1 | | | |

A liquid resin composition was prepared by agitating and mixing components #1 to #7 on a planetary mixer, milling on a three-roll mill with a pitch of 80 µm in three passes, and mixing on a planetary mixer in vacuum.

### Comparative Example 1

A resin composition containing vinylpolysiloxane and Compound A as the base polymer and Compound B and a branched organohydrogenpolysiloxane as the curing agent in a Si-H/Vi ratio of 2.0 and having a silica filler loading of 64 wt% was prepared in accordance with the following formulation.

| # | Component | | pbw |
|---|---|---|---|
| 1 | Base polymer 1: | | |
| | | addition reaction curable silicone varnish in the form of a three-dimensional network vinyl-containing organopolysiloxane resin of 5 to 300 recurring units, free of linear organopolysiloxane chain structure | 12.2 |
| 2 | Base polymer 2: | | |
| | | vinyl-containing linear dimethylpolysiloxane | 12.2 |
| 3 | Base polymer 3: Compound A | | 32.8 |
| 4 | Curing agent 1: Compound B | | 62.2 |
| 5 | Curing agent 2: | | |
| | | branched organohydrogenpolysiloxane | 2.3 |
| 6 | Cure accelerator: | | |
| | | octyl alcohol-modified chloroplatinic acid | |
| | | solution with a concentration of 2 wt% Pt | 0.5 |
| 7 | Filler: spherical silica** | | 229.8 |
| 8 | Epoxy silane coupling agent: | | |
| | | 3-glycidoxypropyltrimethoxysilane | 5.0 |
| 9 | Cure inhibitor: | | |
| | | ethynyl methyl decyl carbinol of formula (19) | 0.5 |
| 10 | Colorant: acetylene black (Denka Black®) | | 3.0 |

| | | | |
|---|---|---|---|
| ** Spherical silica consisted of large-size silica (average particle size d=10 µm), medium-size silica (d=2 µm) and small-size silica (d=0.8 µm) in a weight ratio of 85-10:5, which was surface treated with 1 wt% of 3-glycidoxypropyltrimethoxysilane in Henschel mixer at room temperature for 240 seconds. | | | |

A liquid resin composition was prepared by agitating and mixing components #1 to #10 on a planetary mixer, milling on a three-roll mill with a pitch of 80 µm in three passes, and mixing on a planetary mixer in vacuum.

### Comparative Example 2

A resin composition containing vinylpolysiloxane as the base polymer and branched organohydrogenpolysiloxane as the curing agent in a Si-H/Si-Vi ratio of 2.0 and having a silica filler loading of 82 wt% (high loading) was prepared in accordance with the following formulation.

| # | Component | | pbw |
|---|---|---|---|
| 1 | Base polymer 1: | | |
| | | vinyl-containing linear dimethylpolysiloxane | 87.2 |
| 2 | Curing agent 2: | | |
| | | branched organohydrogenpolysiloxane | 2.8 |
| 3 | Cure accelerator: | | |
| | | octyl alcohol-modified chloroplatinic acid solution with a concentration of 2 wt% Pt | 0.5 |
| 4 | Filler: spherical silica** | | 465.7 |
| 5 | Epoxy silane coupling agent: | | |
| | | 3-glycidoxypropyltrimethoxysilane | 5.0 |
| 6 | Cure inhibitor: | | |
| | | ethynyl methyl decyl carbinol of formula (19) | 0.5 |
| 7 | Colorant: acetylene black (Denka Black®) | | 3.0 |
| | ** Same as in Comparative Example 1 | | |

A liquid resin composition was prepared by agitating and mixing components #1 to #7 on a planetary mixer, milling on a three-roll mill with a pitch of 80 µm in three passes, and mixing on a planetary mixer in vacuum.

### Test Methods

The liquid resin compositions of Examples and Comparative Examples were examined for viscosity, thixotropy index, DSC, bond strength, tensile strength, elongation, tensile modulus, warpage after curing, flow marks, unfilled voids, peel, polishing and reliability by the methods described below. The results are shown in Table 1.

### i) Viscosity and thixotropy index

A viscosity at room temperature was measured by Brookfield programmable rheometer model DV-III Ultra viscometer (cone spindle CP-51) at 1.0 rpm. A thixotropy index was computed by dividing the viscosity at 0.1 rpm by the viscosity at 1.0 rpm as measured by the viscometer.

### ii) DSC measurement

Differential scanning colorimetry measurement by model DSC821e (METTLER-TOLEDO International Inc.).

### iii) Bond strength

The bond strength of resin composition to chip back surface was determined by applying the liquid resin composition to the mirror surface of a silicon dummy wafer of 725 µm thick cut to 10 mm squares and having mirror type surface, mating the mirror surface of a silicon dummy wafer of 725 µm thick cut to 2 mm squares and having mirror type surface to the resin coating on the silicon dummy wafer of 10 mm squares to sandwich the resin coating between the dummy wafers, and heating the assembly at 150°C for 2 hours for curing the resin composition, yielding a test sample. The bond strength was measured by using a tester (Dage Series 4000 Bondtester), holding the sample on a hot plate at 260°C for 40 seconds, and applying a horizontal force to the chip side.

### iv) Tensile strength

The liquid resin composition was molded and heat cured at 150°C for 2 hours to form a plate of 1.0 mm thick, from which a #2 dumbbell specimen was punched out. The tensile strength of the specimen was measured by using autograph Loadcell type SBL-5KN (Shimadzu Corp.) at a grip-to-grip distance of 100.0 mm and a pulling rate of 2.0 mm/min.

### v) Elongation

The liquid resin composition was molded and heat cured at 150°C for 2 hours to form a plate of 1.0 mm thick, from which a #2 dumbbell specimen was punched out. The percent elongation of the specimen was measured by using autograph Loadcell type SBL-5KN (Shimadzu Corp.) at a grip-to-grip distance of 100.0 mm and a pulling rate of 2.0 mm/min.

### vi) Tensile modulus

The liquid resin composition was molded and heat cured at 150°C for 2 hours to form a plate of 1.0 mm thick, from which a #2 dumbbell specimen was punched out. The tensile modulus of the specimen was measured by using autograph Loadcell type SBL-5KN (Shimadzu Corp.) at a grip-to-grip distance of 100.0 mm and a pulling rate of 2.0 mm/min.

### vii) Warpage

The liquid resin composition as compression molded was measured for warpage. A 8-inch wafer of 200 µm thick was used. Wafer Mold MZ407-1 (Apic Yamada Corp.) was set to a resin thickness of 400 µm. The liquid resin composition was compression molded at 110°C for 600 seconds and post-cured (or fully cured) at 150° C for 2 hours. This sample was examined for warpage.

### viii) Flow marks and unfilled voids

A 8-inch wafer of 200 µm thick was used. Wafer Mold MZ407-1 (Apic Yamada Corp.) was set to a resin thickness of 400 µm. The liquid resin composition was compression molded at 110°C for 600 seconds and post-cured (or fully cured) at 150°C for 2 hours into a resin sample of 400 µm thick. This sample was visually observed for flow marks and whether or not unfilled voids were present. Flow marks are white wavy marks extending radially outward from the center of a resin molding. Occurrence of flow marks indicates defective outer appearance, variations of cured physical properties due to non-uniform dispersion of silica, and a concomitant lowering of reliability. Unfilled voids refer to the lack of the resin along the outer periphery of a wafer. In unfilled cases, any void may be mistaken as a notch by a sensor when the wafer is transported to the next station, leading to a misalignment.

### ix) Polishing

A 8-inch wafer of 200 µm thick was used. Wafer Mold MZ407-1 (Apic Yamada Corp.) was set to a resin thickness of 400 µm. The liquid resin composition was compression molded at 110°C for 600 seconds and post-cured (or fully cured) at 150°C for 2 hours into a resin sample of 400 µm thick. This sample was examined for polishing by operating Automatic Surface Grinder DAG810 (DISCO Corp.) at a grinding rate of 1.0 µm/s, a spindle speed of 4,800 rpm, and a stage speed of 300 rpm. The sample was rated good (O) for possible 600 mesh polishing and stable power supply below 8.0 amperes during polishing, and poor (X) for inconsistent 600 mesh polishing.

### x) Reliability

Using a thick-film screen printing machine (Thick Film Printer Type MC212), a die bonding material SFX-513M1 (Shin-Etsu Chemical Co., Ltd.) was printed to a thickness of 20 µm on a 8-inch wafer of 200 µm thick. The wafer in B-stage was diced to 7 mm squares by a dicing tool, yielding semiconductor chips.

Using a flip chip bonder NM-SB50A (Panasonic), the die bonding material-coated semiconductor chips of 7 mm squares and 220 µm thick were die bonded to a 8-inch wafer of 200 µm thick, under conditions: 10N, 150°C and 1.0 sec. A 200-µm thick wafer having semiconductor chips mounted thereon was obtained.

A compression molding machine was loaded with the 200-µm thick wafer having semiconductor chips mounted thereon, over which an appropriate amount of the liquid resin composition was dispensed, molded under a maximum pressure of 30 MPa to 15 MPa, and cured at 110°C for 10 minutes. The amount of the liquid resin composition was adjusted such that the resin as molded had a thickness of 400±10 µm. The molded wafer was heat treated in an oven at 150°C for 2 hours for post curing. Using a dicing tool again, the wafer was diced into 7.1 mm squares, obtaining singulated resin-encapsulated semiconductor chips with a resin thickness of 400 µm.

Using a flip chip bonder NM-SB50A (Panasonic) and a die bonding material SFX-513S (Shin-Etsu Chemical Co., Ltd.), the singulated resin-encapsulated semiconductor chips were die bonded to a BT substrate, under conditions: 10N, 150°C and 1.5 sec. This was heat treated in an oven at 150°C for 4 hours for post curing, yielding a BT substrate having resin-encapsulated semiconductor chips mounted thereon.

Using a transfer molding machine G-Line Press (Apic Yamada Corp.), a molding compound was transfer molded over the BT substrate having resin-encapsulated semiconductor chips mounted thereon under conditions: 175°C, 90 sec, and 90 MPa to a thickness of 1.5 mm. Using a dicing tool again, the substrate was diced to 10.0 mm squares, yielding singulated molding compound resin-encapsulated semiconductor chip-bearing BT substrates (i.e., semiconductor devices).

The singulated semiconductor devices were subjected to a moisture absorption test at 85°C and 85% RH for 168 hours. They were passed three times through a reflow oven preset to a maximum temperature of 260°C and a holding time of 30±3 seconds at 255-260°C as a soldering heat resistance test whereupon any peel was inspected by visual observation.

### xi) Thermal cycling test (TCT)

Using a compact thermal cycling tester TSE-11 (ESPEC Corp.), the singulated molding compound resin-encapsulated semiconductor chip-bearing BT substrates were subjected to automatic thermal cycling between -55°C/15 minutes and +125°C/15 minutes. At the initial (0 cycle), any peel within the semiconductor chip was detected in a non-destructive manner using a ultrasonic flaw detector QUANTUM350 (Sonix Co.) with a probe at 75 MHz. Similar detection was carried out after 250 cycles, 500 cycles and 750 cycles. The results are shown in Table 1.

The sample was rated "no peel" (OK) when the total of peeled areas was less than 5% of the semiconductor chip area and "peel" (NG) when the total of peeled areas was equal to or more than 5%.

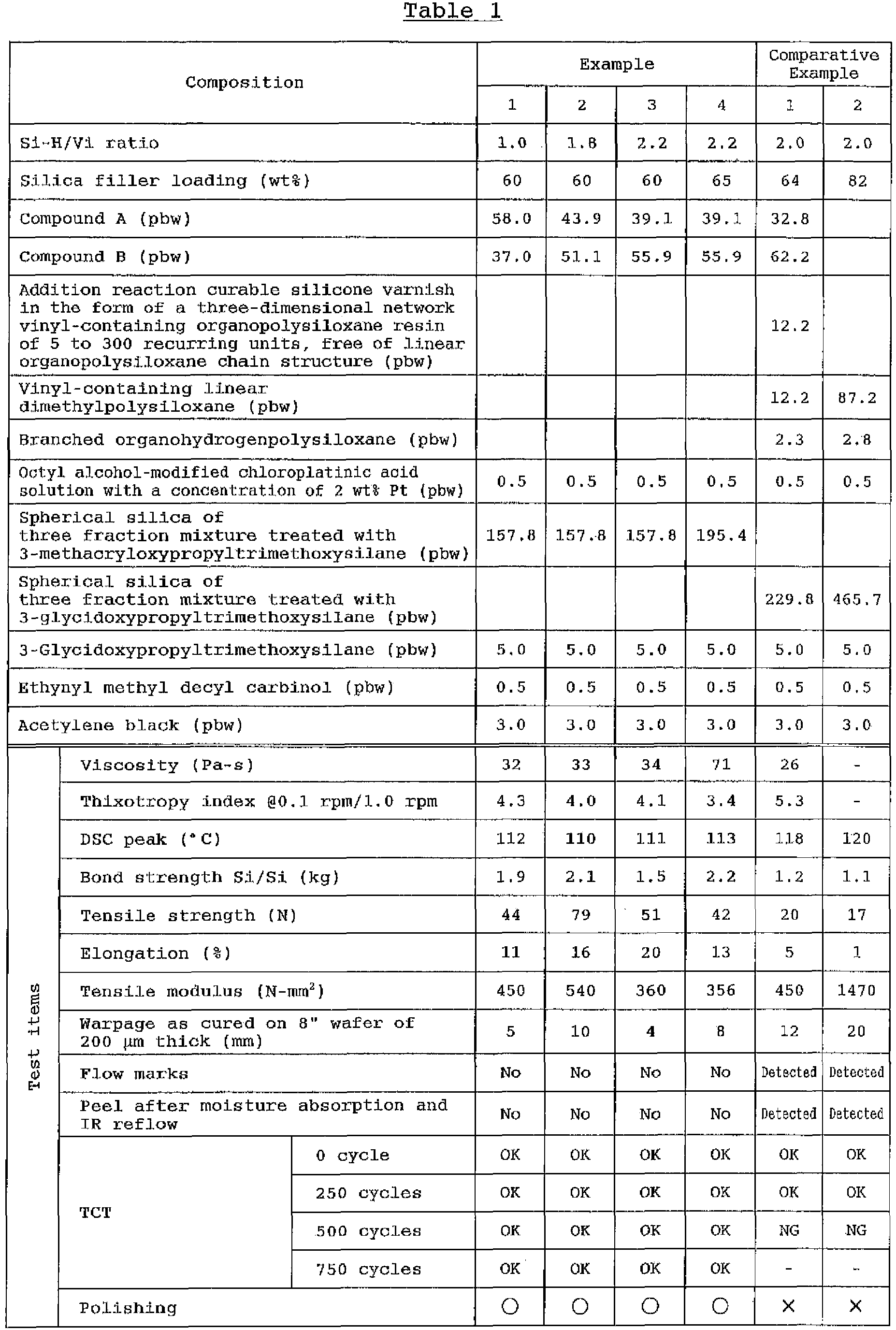

Examples 1 to 4 are liquid resin compositions using only those resins derived from both end allyl isocyanurate ring-terminated organopolysiloxane polymer (Compound A) and isocyanurate ring-containing hydrogen-terminated polysiloxane polymer (Compound B) as the base polymer and curing agent (or crosslinker), respectively. Even though the Si-H/allyl ratio varied from 1.0 to 1.8 or 2.2, semiconductor devices fabricated by compression molding the liquid resin compositions showed neither minor peel nor peel in the peel test. Peel-resistant semiconductor devices were provided.

After the liquid resin compositions of Examples 1 to 4 were compression molded and post-cured at 150°C for 2 hours, neither flow marks nor unfilled voids were detected on visual observation of the outer appearance. Polishing raised no problems. The reliability was acceptable because neither minor peel nor peel was detected in the thermal cycling test over 750 cycles.

In contrast, when the liquid resin compositions of Comparative Examples 1 and 2 were compression molded and post-cured at 150°C for 2 hours, flow marks were detected. Specifically, white flow marks developed where the resin was placed prior to compression molding and nearby. No unfilled voids were detected. Polishing was problematic. The reliability test became NG within 750 cycles.

## Claims

1. A thermosetting resin composition for semiconductor encapsulation comprising
(A) an organopolysiloxane polymer having an allyl isocyanurate ring structure at both ends of its molecular chain, represented by the general formula (1) as an alkenyl-containing organopolysiloxane, 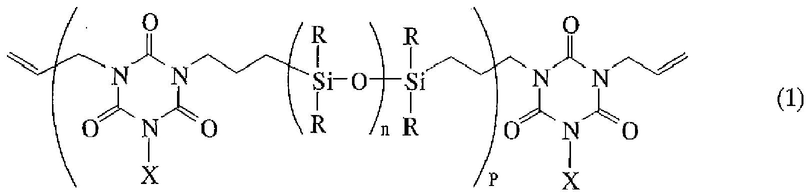 wherein X is each independently a monovalent hydrocarbon group free of aliphatic unsaturation, R is each independently alkyl or phenyl, n is an integer of 1 to 50, and P is an integer of 1 to 30,
(B) an isocyanurate ring-containing organohydrogenpolysiloxane polymer having at least two silicon-bonded hydrogen atoms (Si-H groups) at ends of its siloxane chain, represented by the general formula (2) as an epoxy-free organohydrogenpolysiloxane, 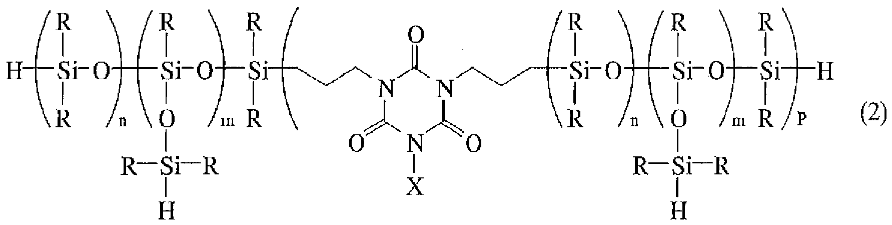 wherein X is each independently a monovalent hydrocarbon group free of aliphatic unsaturation, R is each independently alkyl or phenyl, n is an integer of 1 to 50, m is an integer of 0 to 5, and P is an integer of 1 to 30, wherein the recurring siloxane units may be randomly linked, in such an amount that 0.8 to 4.0 moles of Si-H groups in component (B) are present per mole of allyl groups in component (A),
(C) a catalytic amount of a cure accelerator, and
(D) a spherical inorganic filler consisting of (D-1) a fraction having an average particle size of 10.0 to 50.0 µm, (D-2) a fraction having an average particle size of 1.1 to 5.0 µm, and (D-3) a fraction having an average particle size of 0.1 to 1.0 µm in a weight ratio (D-1) : (D-2) : (D-3) of 95-70 : 3-20 : 2-10, provided that the total of (D-1), (D-2) and (D-3) is 100, in an amount of 30 to 900 parts by weight per 100 parts by weight of components (A) and (B) combined,
the composition being free of an alkenyl-containing organopolysiloxane other than component (A) and an epoxy-free organohydrogenpolysiloxane other than component (B).

2. The composition of claim 1 wherein the spherical inorganic filler (D) is spherical silica.

3. The composition of claim 1 or 2 wherein the spherical inorganic filler (D) has been surface treated with a silane coupling agent.

4. The composition of claim 3 wherein the silane coupling agent is at least one member selected from the group consisting of vinytrimethoxysilane, vinyltriethoxysilane, 2-(3,4-epoxycyclohexyl)ethyltrimethoxysilane, 3-glycidoxypropylmethyldimethoxysilane, 3-glycidoxypropyltrimethoxysilane, 3-glycidoxypropylmethyldiethoxysilane, 3-glycidoxypropyltriethoxysilane, p-styryltrimethoxysilane, 3-methacryloxypropylmethyldimethoxysilane, 3-methacryloxypropyltrimethoxysilane, 3-methacryloxypropylmethyldiethoxysilane, 3-methacryloxypropyltriethoxysilane, 3-acryloxypropyltriethoxysilane, and 3-ureidopropyltriethoxysilane.

5. A resin-encapsulated semiconductor device fabricated by coating the thermosetting resin composition of any one of claims 1 to 4 to one surface of a silicon wafer having at least one semiconductor element formed therein in entirety under pressure or under reduced pressure in a vacuum atmosphere, heat curing the composition to encapsulate the wafer with a cured resin layer, polishing the cured resin layer, and dicing the wafer into singulated devices.
